(19) Europäisches Patentamt
European Patent Office
Office européen des brevets

(11) **EP 2 130 338 B1**

(12) **EUROPEAN PATENT SPECIFICATION**

(45) Date of publication and mention
of the grant of the patent:
**28.12.2011 Bulletin 2011/52**

(51) Int Cl.:
***H04L 25/02*** (2006.01)      ***H04L 27/26*** (2006.01)
***H03G 3/20*** (2006.01)

(21) Application number: **08731357.3**

(22) Date of filing: **04.03.2008**

(86) International application number:
**PCT/US2008/055807**

(87) International publication number:
**WO 2008/109607 (12.09.2008 Gazette 2008/37)**

(54) **Apparatus and method accounting for effects of discontinuities at the output of automatic gain control in a multi carrier system**

Vorrichtung und Verfahren für Diskontinuitätseffekte am Ausgang einer automatischen Verstärkungsregelung in einem Multicarrier-System

Appareil et procédé rendant compte des effets de discontinuités au niveau de la sortie de commande automatique de gain dans un système multiporteuse

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **05.03.2007 US 893060 P**
**05.03.2007 US 893058 P**
**12.07.2007 US 777263**

(43) Date of publication of application:
**09.12.2009 Bulletin 2009/50**

(73) Proprietor: **QUALCOMM Incorporated**
**San Diego, California 92121-1714 (US)**

(72) Inventor: **BREHLER, Matthias**
**San Diego, California 92121-1714 (US)**

(74) Representative: **Carstens, Dirk Wilhelm**
**Wagner & Geyer**
**Gewürzmühlstrasse 5**
**80538 München (DE)**

(56) References cited:
**US-A- 4 630 305**

• LINDE L P: "An AGC strategy for adaptive digital modems in frequency hopping applications" COMMUNICATIONS AND SIGNAL PROCESSING, 1989. COMSIG 1989. PROCEEDINGS., SOUTHERN AFRICAN CONFERENCE ON STELLENBOSCH, SOUTH AFRICA 23 JUNE 1989, NEW YORK, NY, USA,IEEE, US, 1 January 1989 (1989-01-01), pages 19-24, XP010042974 ISBN: 978-0-87942-713-9

• JINGMING WANG ET AL: "Performance of linear interpolation-based MIMO detection for MIMO-OFDM systems" WIRELESS COMMUNICATIONS AND NETWORKING CONFERENCE, 2004. WCNC. 2004 IE EE ATLANTA, GA, USA 21-25 MARCH 2004, PISCATAWAY, NJ, USA,IEEE, vol. 2, 21 March 2004 (2004-03-21), pages 981-986, XP010708264 ISBN: 978-0-7803-8344-9

EP 2 130 338 B1

## Description

### Reference to Related Applications for Patent

The present Application for Patent is related to the following co-pending U.S. Patent Applications:

"TIMING CORRECTIONS IN A MULTI CARRIER SYSTEM AND PROPAGATION TO A CHANNEL ESTIMATION TIME FILTER" by Bojan Vrcelj et al., having a U.S. Patent Application No. 11/373,764, filed March 9, 2006, assigned to the assignee hereof.

"TIMING ADJUSTMENTS FOR CHANNEL ESTIMATION IN A MULTI CARRIER SYSTEM" by Matthias Brehler et al., having a U.S. Patent Application No. 11/777,251, filed July 12, 2007, assigned to the assignee hereof.

## BACKGROUND

Field

The present disclosure relate to apparatus and methods accounting for automatic gain control (AGC) in a multi carrier wireless system, and, more particularly, to adjusting combining coefficients to account for AGC, which are used to combine pilot tone interlaces in an interlace filter for determining channel estimation.

## Background

Orthogonal frequency division multiplexing (OFDM) is a method of digital modulation in which a signal is split into several narrowband channels at different carrier frequencies orthogonal to one another. These channels are sometimes called subbands or subcarriers. In some respects, OFDM is similar to conventional frequency-division multiplexing (FDM) except in the way in which the signals are modulated and demodulated. One advantage of OFDM technology is that it reduces the amount of interference or crosstalk among channels and symbols in signal transmissions. Time-variant and frequency selective fading channels, however, present problems in many OFDM systems.

In order to account for time varying and frequency selective fading channels, channel estimation is used. In coherent detection systems, reference values or "pilot symbols" (also referred to simply as "pilots") embedded in the data of each OFDM symbol may be used for channel estimation. Time and frequency tracking may be achieved using the pilots in channel estimation. For example, if each OFDM symbol consists of N number of subcarriers and P number of pilots, N-P number of the subcarriers can be used for data transmission and P number of them can be assigned to pilot tones. The P number of pilots are sometimes uniformly spread over the N subcarriers, so that each two pilot tones are separated by N/P-1 data subcarriers (or, in other words, each pilot occurs every $N/P^{th}$ carrier). Such uniform subsets of subcarriers within an OFDM symbol and over a number of symbols occurring in time are called interlaces.

In one area of application, OFDM is used for digital broadcast services, such as with Forwards Link Only (FLO), Digital Video Broadcast (DVB-T/H (terrestrial/handheld)), and Integrated Service Digital Broadcast (ISDB-T) standards. In such wireless communication systems, channel characteristics in terms of the number of channel taps (i.e., the number of samples or "length" of a Finite Impulse Response (FIR) filter that is used to represent the channel of a received signal) with significant energy, path gains, and the path delays are expected to vary quite significantly over a period of time. In an OFDM system, a receiver responds to changes in the channel profile by selecting the OFDM symbol boundary appropriately (i.e., correction of window timing) to maximize the energy captured in a fast Fourier transform (FFT) window.

In OFDM receivers it is common for a channel estimation block in a receiver to buffer and then process pilot observations from multiple OFDM symbols, which results in a channel estimate that has better noise averaging and resolves longer channel delay spreads. This is achieved by combining the channel observations of length P from consecutively timed OFDM symbols into a longer channel estimate in a unit called the time filtering unit. Longer channel estimates in general may lead to more robust timing synchronization algorithms. Automatic gain control (AGC), however, can limit the performance of interlacing combining. In particular, AGC introduces discontinuities in a channel, adversely affecting interlace combining with increasing severity the more interlaces that are combined, such as in DVB and ISDB system in particular. The adverse effects of AGC on the combining of interlaces degrades the channel estimation, accordingly.

Attention is drawn to a paper by LINDE L P, entitled "An AGC strategy for adaptive digital modems in frequency hopping applications" COMMUNICATIONS AND SIGNAL PROCESSING, 1989. COMSIG 1989. PROCEEDINGS., SOUTHERN AFRICAN CONFERENCE ON STELLENBOSCH, SOUTH AFRICA 23 JUNE 1989, NEW YORK, NY, USA,IEEE, US, 1 January 1989 (1989-01-01), pages 19-24, XP010042974 ISBN: 978-0-87942-713-9

SUMMARY

In accordance with the present invention, a method for adjusting for the effect of AGC, as set forth in claim 1, and an apparatus for use in a wireless transceiver, as set forth in claim 9, is provided. Embodiments of the invention are claimed in dependent claims.

**BRIEF DESCRIPTION OF THE DRAWINGS**

FIG. 1 illustrates a block diagram of an exemplary transceiver according to the present disclosure.

FIG. 2 is a diagram of an exemplary pilot tone staggering scheme used in particular OFDM standards.

FIG. 3 is a diagram of a visualization of combining pilot tone of the exemplary pilot tone staggering scheme of FIG. 2.

FIG. 4 illustrates a plot of a channel gain over time in a system without automatic gain control.

FIG. 5 illustrates a plot of a channel gain over time in a system employing automatic gain control.

FIG. 6 a method for determining adjusted combining coefficients accounting for automatic gain control timing in a wireless device.

FIG. 7 illustrates an apparatus for determining adjusted combining coefficients accounting for automatic gain control timing in a wireless device.

FIG. 8 illustrates an exemplary plot of a simulation showing improved performance characteristics of a system accounting for automatic gain control over a system that does not account for automatic gain control.

**DETAILED DESCRIPTION**

The present disclosure discusses apparatus and methods for adjusting for the effects of automatic gain control when combining pilot interlaces in an interlace filter of a communication system, such as an OFDM system. The disclosed methods and apparatus achieve reversal of the effects of discontinuities introduced by automatic gain control (AGC) when combining pilot interlaces. Accordingly, channel estimation, and, thus, transceiver performance is improved

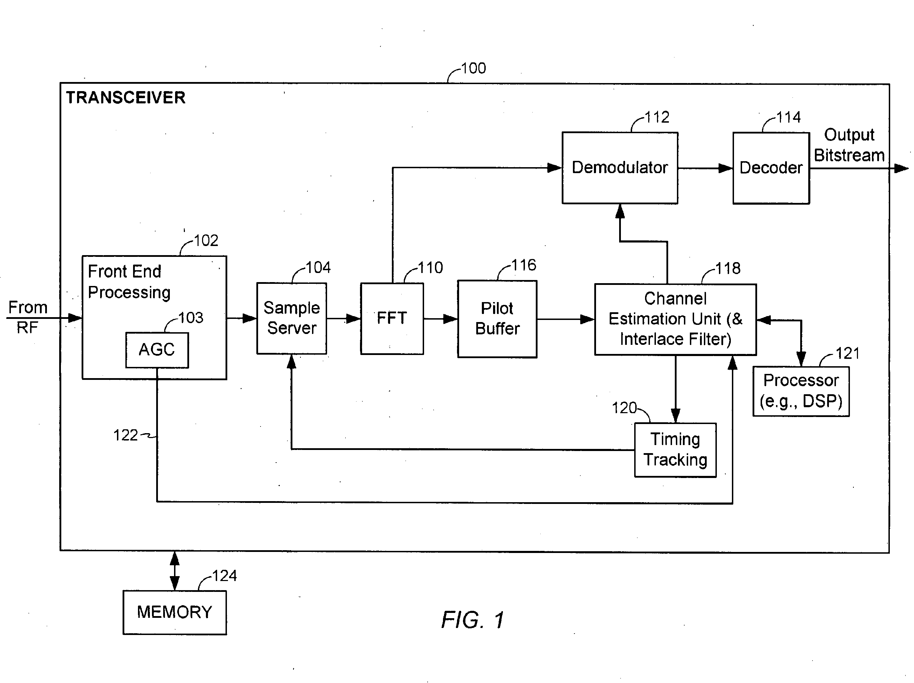

FIG. 1 illustrates a block diagram of an exemplary OFDM transceiver or portion of a transceiver according to the present disclosure. The system of FIG. 1, in particular, may employ the disclosed techniques for making timing adjustments using pilot tones, which are used for channel estimation. The system 100, which may be a transceiver or one or more processors, hardware, firmware, or a combination thereof, receives a transmitted RF signal as shown. A front end processing block 102 receives the RF signal and performs various processing functions including analog-to-digital conversion; down conversion, and AGC (Automatic Gain Control) unit 103. The AGC unit 103 may further include low noise amplifier (LNA) control, a digital variable gain amplifier (DVGA), or a combination thereof.

After front end processing 102 and AGC 103, the resultant signals are sent to a sample server 104, which effects the actual timing window (e.g., the FFT timing window) for sampling the subcarriers within the signal. The output of the sample server 104, which is a synchronized digital signal, is then input to an optional frequency rotator , which operates in conjunction with and under control of a frequency tracking block to cause rotation or shifting of the phase of the signal in frequency in order to make fine adjustments or corrections in frequency.

The signals from either sample server 104 or frequency rotator 106, if utilized, are sent to a fast Fourier Transform (FFT) 110, which performs a discrete Fourier transform of the signal. More particularly, the FFT 110 extracts the data carriers from the pilot carriers. The data is sent to a demodulator 112 for demodulation of the data, and a subsequent decoder 114 for decoding of the data according to any suitable encoding scheme utilized. The output of the decoder is a bit steam for use by other processors, software, or firmware within a transceiver device.

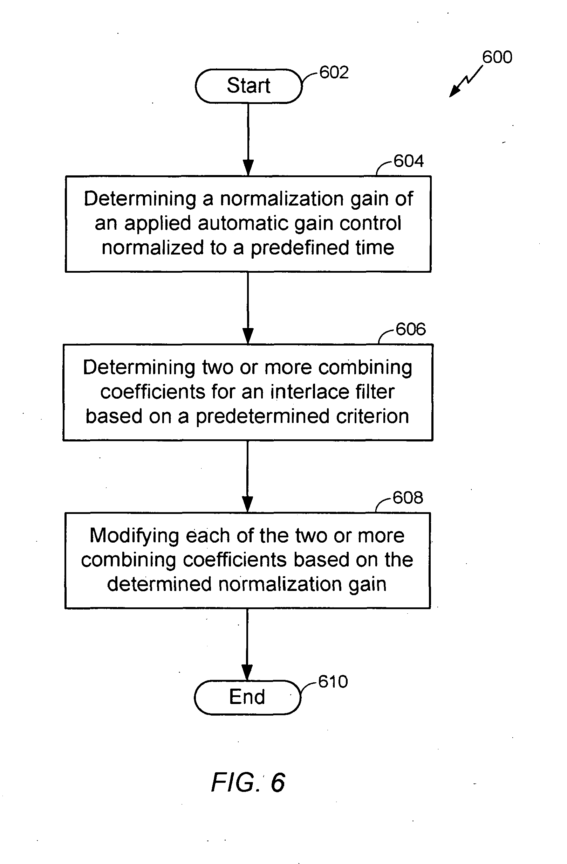

The pilot tones extracted by FFT 110 are sent to a pilot buffer 116, which buffers a number of pilot interlaces from one or more OFDM symbols. According to an example disclosed herein, the buffer 116 may be configured to buffer multiple interlaces for use in combining the interlaces. The buffered pilot interlaces are delivered by buffer 116 to a channel estimation block or unit 118, which estimates the channels using the interlaced pilot tones inserted by the transmitter (not shown) into the symbols of the digital signal. As will be discussed further, the channel estimation yields a channel impulse response (CIR) $\hat{h}_{k,n}$ to be used in timing tracking and a channel frequency response $\hat{H}_{k,n}$ to be used for demodulation of the channel data by demodulator 112. The channel impulse response (CIR) $\hat{h}_{k,n}$, in particular, is delivered to a timing tracking block 120, which effects a timing tracking algorithm or method to determine a timing decision for the FFT window that is used by sample server 104. The system 100 also includes a processor 121, such as a digital signal processor (DSP), in communication with the channel estimation unit 118 and may be utilized to implement various processing operations, such as those that will be discussed later in connection with the method of FIG. 6.

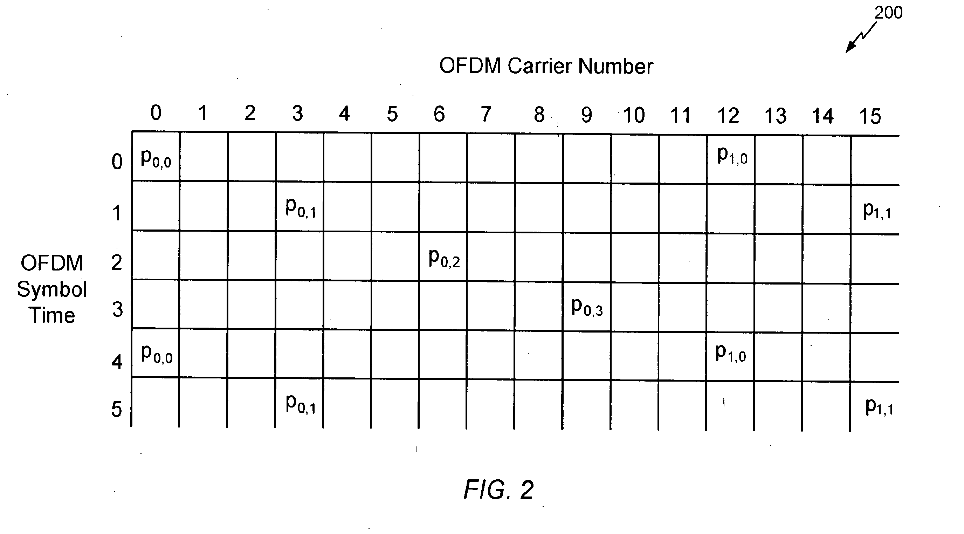

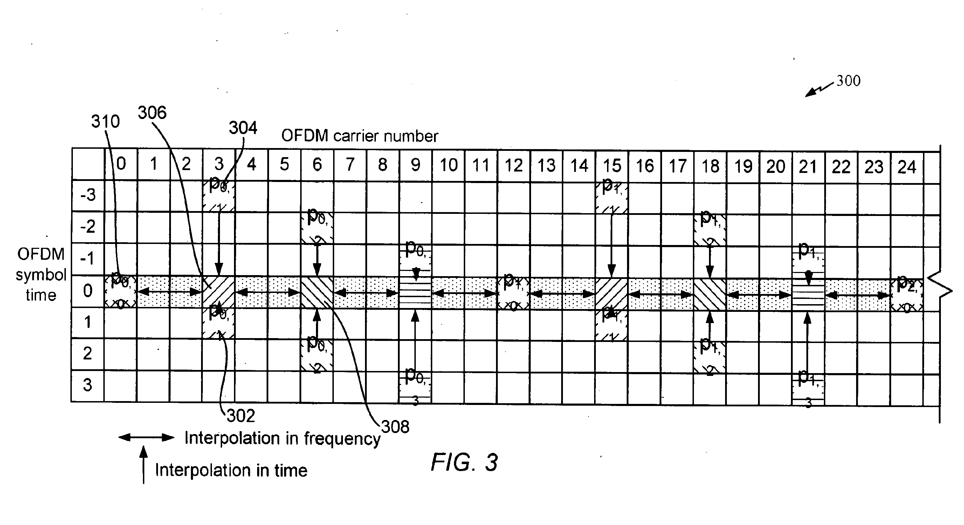

As mentioned above, in a transceiver used in an OFDM system, a channel estimation unit or block (e.g., 118) is utilized to obtain a channel transfer function estimate $\hat{H}_{k,n}$ of the channel at each carrier k and OFDM symbol time n for demodulation of the data symbols and an estimate $\hat{h}_{k,n}$ of the corresponding channel impulse response (CIR) for use in time tracking. In both DVB-T/H and ISDB-T systems, in particular, the pilot tones are transmitted according a predetermined interlace staggering scheme 200 as illustrated by FIG. 2, which illustrates the scheme for the first few carriers k and symbol times n. As may be seen in FIG. 2, at a given symbol time *n*, pilot tones *p* are inserted at every 12th carrier for a total of up to $N_K/12$ pilots tones per OFDM symbol *n* (e.g., at symbol time 0 in FIG. 3 there can be a $N_K/12$ number of pilot tones where carrier 0 is used for a pilot tone, but $N_K/12$-1 for symbols having pilots staggered such as a OFDM symbol time 1, 2, and 3 in FIG. 2), where $N_K$ is the total number of carriers. For subsequent symbols, insertion of pilot tones is offset by $3\times(n \bmod 4)$ tones, based from time 0 (*n*=0). Accordingly, in symbol 1 the first pilot tone is inserted at carrier 3, in symbol 2 the first pilot tone is inserted at carrier 6, and so forth. As further illustrated, pilot tones $p_{l,m}$ are inserted every *l*th carrier for a respective interlace *m*, where *l* is equal to 12 in this example, and m= mod4 (i.e., $0 \le m \le 3$), where mod signifies a modulo operation. Thus, after four OFDM symbols (e.g., OFDM symbol times 0-3), the pattern repeats. For example, FIG. 2 illustrates for the first pilot (i.e., *l*=0), the interlace pattern is staggered for m=0 to 3, as may be seen by the four pilots $p_{0,0}$, $p_{0,1}$, $p_{0,2}$, and $p_{0,3}$ inserted in symbols 0, 1, 2, and 3, respectively.

As an example, known channel estimation algorithms in systems employing the interlace illustrated in FIG. 2 typically combine pilot interlaces from seven (7) consecutive OFDM symbols, which are buffered in a pilot interlace buffer (not shown), in a paired fashion to find a channel estimate for a time *n*. In particular, each pair of pilot tones corresponds to the same pilot (i.e., *l*th pilot) at different OFDM symbol time instances and they are combined to estimate the channel corresponding to the time of data. As an example of such combining, FIG. 3 illustrates a diagram 300 of the exemplary interlacing of pilot symbols p shown in FIG. 2 with further visual representation of the combining of pilot tones. As illustrated, a first pilot $p_{l,m}$ for *l*=0, for example, is combined in time for each of the carriers (i.e., interpolated in time). As may be seen in FIG. 3, a pair 302, 304 of pilots ($p_{0,1}$) at carrier 3 (i.e., an offset of 3 carriers ($3\times n \bmod 4$), thus part of same m+1 interlace) and times *n+1* and *n-3*, respectively, are combined to the time of symbol time *n* (*n* being 0 in this example) as indicated with vertical arrows. Additionally, an interpolated pilot tone 306 may then be interpolated in frequency with other interpolated pilot tones 308 or a pilot tone extant in the n time OFDM symbol 310, as illustrated by the horizontal arrows in FIG. 3.

Combining pilot tones may be effected using any known techniques including interpolation techniques. It is further noted that the interlaces may be combined in the frequency or time domain, as will be explained in detail below. From a theoretical point of view, both strategies of combining (frequency or time domain) yield exactly the same performance. It is noted, however, that combining in time may present less stress on a channel IFFT in a fixed point implementation (since its shorter).

In utilizing the pilot scattering scheme illustrated in FIGs. 2 and 3, all available scattered pilot tone positions are used for combining of pilot tones. As a result, the channel impulse response (CIR) covers 1/3 of the useful OFDM symbol time (4/3 of the maximum guard).

A first strategy for combing pilot tones of the interlaces is combining in the frequency domain, as mentioned above, using a filter. Combining the pilot tones in the frequency domain can be mathematically expressed as shown in equation (1) below providing the pilot tone estimate $\overline{H}_{k,n}$.

$$\overline{H}_{k,n} = \sum_{l=-\lceil N_c/4 \rceil}^{\lceil N_{nc}/4 \rceil} m_{l,[n-k]_4} P_{\lfloor k/4 \rfloor, [n-([n-k]_4 - l \cdot 4)]_4}, \quad 0 \le k < N_P, \qquad (1)$$

In equation (1 above, $N_P$ is the length of the final time-domain channel estimate, $m_{l,[n-k]_4}$ are the filter coefficients of the filter, and $N_c$ and $N_{nc}$ are the causal and non-causal filter lengths, respectively. It is noted that the notation $[\ ]_4$ is an abbreviated notation where the subscript 4 is a reminder of the modulo operation xmod4. For simplicity only filtering of pilot tones corresponding to the same interlace as the filter output is allowed. In other words, the filter works vertically as indicated in FIG. 3 for the presently disclosed example where $N_c = N_{nc} = 3$. According to this example, the filter coefficients $m_{l,[n-k]4}$ are chosen to effect linear interpolation between two pilot-tones and are shown in Table 1 below. As may be seen in the table, the filter coefficients effectively weight the effect that those tones closer to carrier 0 (e.g., k=1), in this example, are given more weight than those tones (e.g., k=3) farther away in frequency.

Table 1 - Filter coefficients *m* for linear interpolation

| k | 0 | 1 | 2 | 3 |
|---|---|---|---|---|
| $m_{0,k} =$ | 1 | 0.75 | 0.5 | 0.25 |
| $m_{1,k} =$ | 0 | 0.25 | 0.5 | 0.75 |

It is noted that a more general filter could incorporate pilot tones from other interlaces (i.e., also work diagonally), with an according increase in complexity. After filtering the IFFT of the $\overline{H}_{k,n}$ is taken, taps below a certain threshold are set to zero, and after zero-padding with $2N_P$ zeros (to interpolate in frequency) an FFT is taken to arrive at the final channel estimate $\hat{H}_{k,n}$, where $N_P$ is the length of the final time-domain channel estimate.

While combining the interlaces in frequency domain, as discussed above, is straightforward, another strategy is to combine interlaces in the time domain, as was contemplated in U.S. Patent Application No. 11/373,764,

for a forward link only (FLO) system. In a present example, the same time domain combining can be done for DVB-T/H and ISDB-T OFDM systems, for example. Due to the four (4) interlaces in the DVB-T/H and ISDB-T systems (see e.g., FIGs. 1 and 2), however, the mechanics are slightly different than a FLO system where only two (2) interlaces are used to obtain the "actual" and "excess" channel taps. In the present example, 4 different interlaces, such as are used in DVB-T/H and ISDB-T systems, are used to obtain 4 segments of the complete channel impulse response (CIR).

First, an IFFT of the pilot tones of each interlace is taken. More specifically, zero-padding of the $\dfrac{N_K}{12}$ (or

$\dfrac{N_K}{12}+1$ for interlace 0) pilot tones $P_{l,m}$ to $N_{IL}$ is performed, where $N_K$ represents the number of carriers, and $N_{IL}$ represents the length of interlaces in frequency after zero padding (i.e., extending a signal (or spectrum) with zeros to extend the time (or frequency band) limits). In DVB-H systems, for example, the number of carriers $N_K$ is 1705, 3409, or 6817 dependent on the mode of operation. ISDB-T systems as a further example typically have 108, 216, or 432 carriers $N_K$ dependent on the mode of operation. In DVB-H systems, for examples, the length of the interlaces $N_{IL}$ are 256 or 512 or 1024, dependent on the mode of operation. ISDB-T systems, as another example, would have interlaces lengths of 16 or 32 or 64 dependent on the mode of operation. After zero padding of the $\dfrac{N_K}{12}$ tones, an IFFT is taken to obtain a time-domain estimate $\tilde{h}_{k,n}$ of the channel per interlace, governed by the following equation (2):

$$\tilde{h}_{k,n} = \frac{1}{N_{IL}} \sum_{l=0}^{L} P_{l,[n]_4} e^{j\frac{2\pi}{N_{IL}}lk}, \quad L = \frac{N_K}{12} \text{ for } m=0, \quad L = \frac{N_K}{12}-1 \text{ for } m \neq 0 \quad (2)$$

In preparation to combine the time-domain interlace channel estimates having a length $N_{IL}$ to a channel estimate with length $N_P$ (where $N_P = 4 N_{IL}$), the phases of the $\tilde{h}_{k,m}$ need to be adjusted. Accordingly, the channel estimate is adjusted according to the following equation (3):

$$b_{k,n} = e^{j\frac{2\pi}{N_P}[n]_4 k} \tilde{h}_{k,n}, \quad 0 \leq k \leq N_{IL}-1. \quad (3)$$

where $b_{k,m}$ are referred to as the interlace buffers. Because each interlace channel estimate is to be used four (4) times for the calculation of channel estimates at consecutive OFDM symbol times, the $b_{k,m}$ are buffered, requiring at least 7 $N_{IL}$ complex storage spaces for the presently disclosed example.

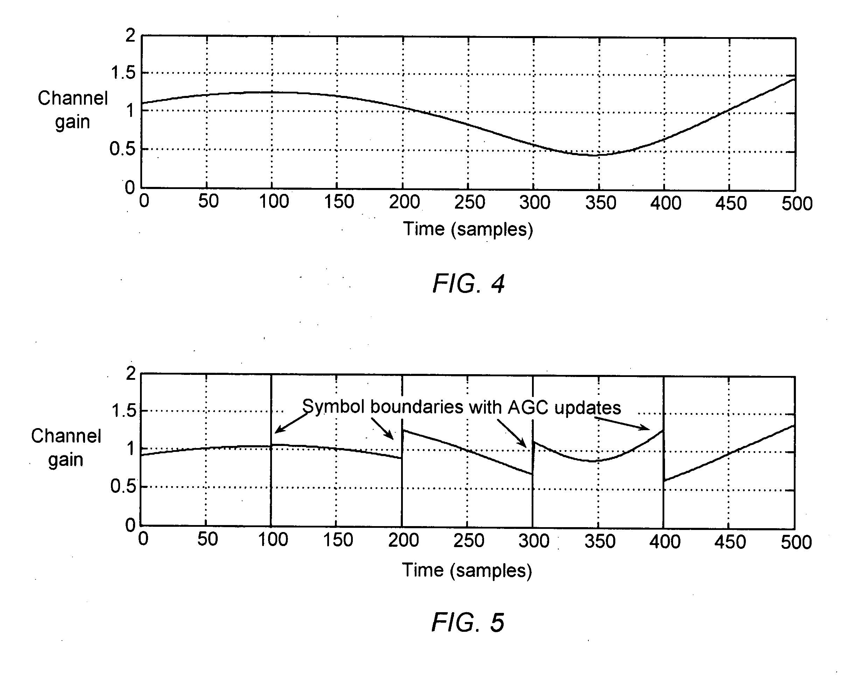

The interlace buffers can be combined to form a time-domain channel estimate $\overline{h}_{k,n}$ having a length of $N_P = 4N_{IL}$. The channel estimate $\overline{h}_{k,n}$ may then be split into four segments as illustrated in FIG. 4. Each of the four $u$ segments has a length of $N_{IL}$, where each of the segments $u$ can be obtained from the buffers as proved by the following relationship:

$$\overline{h}_{k+uN_{IL},n} = \frac{1}{4} \sum_{l=-N_c}^{N_{nc}} m_{\lceil l/4 \rceil,[-l]_4} e^{j\frac{\pi}{2}[n+l]_4 u} b_{k,n+l}, \quad 0 \leq k \leq N_{IL}-1, \quad 0 \leq u \leq 3 \quad (4)$$

For the same filter coefficients $m_{l,k}$ the time-domain channel taps obtained here are simply the IFFT of the combined pilot tones of equation (1) above. Combining in the time domain may simply be viewed as one way of implementing a fast algorithm for the discrete Fourier transform (DFT) of the pilot tones combined in frequency. More particularly, the equivalence is derived as follows for the case that we use exactly four consecutive interlaces and all four (4) filter coefficients $m_{l,k}$ are one (a more general case with filtering will be considered later). Then each time interlace $\tilde{h}_{k,m}$

can be viewed as being obtained from a frequency-domain channel $\overline{H}_{k.n}$ by down-sampling and advancing (in frequency). Since down-sampling in frequency corresponds to aliasing in time and shifting in frequency to a phase shift in time one skilled in the art will appreciate that the following relationship in equation (5) below governs.

$$\tilde{h}_{k.n} = \sum_{l=0}^{3} e^{-j\frac{2\pi}{N_{\mathrm{P}}}[n]_4(k+lN_{\mathrm{IL}})} \overline{h}_{k+lN_{\mathrm{IL}}.n}. \qquad (5)$$

For the sake of the present derivation of time domain interlace combining, it is assumed that the channel is constant. Thus, to obtain the $\overline{h}_{k+uN_{IL}n}$ back from the interlaces $\tilde{h}_{k,n}$ coefficients $\alpha_{kmu}$ can be found such according to equation (6) as follows:

$$\sum_{m=0}^{3} \alpha_{kmu} \tilde{h}_{k.n-m} = \overline{h}_{k+uN_{\mathrm{IL}}.n}. \qquad (6)$$

which may be achieved if:

$$\sum_{m=0}^{3} \alpha_{kmu} e^{-j\frac{2\pi}{N_{\mathrm{P}}}m(k+lN_{\mathrm{IL}})} = \delta(l-u) \quad \forall 0 \le k \le N_{\mathrm{IL}} - 1, \qquad (7)$$

which ensures that in the linear combination of equation (6) that the coefficients in front of $\overline{h}_{k+uNIL,n-m}$ sum up to unity and for all other aliases the coefficients sum up to zero.
As one skilled in the art will recognize, the solution for $\alpha_{kmu}$ is thus

$$\alpha_{kmu} = \frac{1}{4} e^{+j\frac{2\pi}{N_{\mathrm{P}}}mk} e^{+j\frac{2\pi}{N_{\mathrm{P}}}muN_{\mathrm{IL}}}. \qquad (8)$$

By further recognizing that the ratio $\dfrac{N_{\mathrm{IL}}}{N_{\mathrm{P}}} = \dfrac{1}{4}$, the deramping and interlace buffer combining coefficients can be extracted from this solution.

The additional filtering introduced with the coefficients $m_{l,k}$ can be viewed to only operate on a given interlace, so that it is equivalent in time and frequency domain (i.e., linear operations are interchangeable). Whether the filtered interlaces are then combined in frequency or time domain is the same according to the presently disclosed methodologies. Accordingly, equation (4) above can be rewritten as the following equation (9):

$$\overline{h}_{k+uN_{\mathrm{IL}}.n} = \frac{1}{4} \sum_{r=0}^{3} e^{j\frac{\pi}{2}[n-r]_4 u} e^{j\frac{2\pi}{N_{\mathrm{P}}}[n-r]_4 k} \sum_{l=-\lceil N_c/4 \rceil}^{\lceil N_{ac}/4 \rceil} m_{l,r} \tilde{h}_{k.n-(r-l\cdot4)}, \qquad (9)$$

where the inner sum corresponds to the interlace filtering and the outer-sum corresponds to the phase deramping and interlace combining in time domain.

As discussed above, the combining coefficients ($m_{l,k}$ in this presentation) for combining the pilot interlaces are constant, such as may be seen in the Table 1 above where the coefficients are linearly interpolated in time. The coefficients $m_{l,k}$, however, may be chosen according to different criteria/methodologies. For example, the coefficients could be chosen to minimize the minimum mean square error (MMSE) between the actual channel and the channel estimate. It is noted that designing the combining coefficients of the interlace filter according to the MMSE criterion exploits the time correlations of the fade process (which are the same in frequency and time domain).

An exemplary derivation for an MMSE interlace estimator is as follows. The observed pilot tones $Z_{k.n}$ are assumed to be:

$$Z_{k,n-3} = H_{k,n-3} + \eta_{k,n-3},$$
$$Z_{k,n+1} = H_{k,n+1} + \eta_{k,n+1}, \qquad (10)$$

where $H_{k,n}$ is the complex channel coefficient of carrier $k$ at time $n$ and $\eta_{k,n}$ is complex additive white Gaussian noise (AWGN). For simplicity, it is noted that pseudorandom binary sequence (PRBS) spreading is ignored in this discussion. The observations are then combined to form the following estimate:

$$\hat{H}_{k,n} = \begin{bmatrix} m_{0,3}^\dagger & m_{1,3}^\dagger \end{bmatrix} \begin{bmatrix} Z_{k,n-3} \\ Z_{k,n+1} \end{bmatrix} = \mathbf{m}^\dagger \mathbf{Z}_k. \qquad (11)$$

Note that this can easily be extended to more pilot tones and other time offsets. For purposes of this example, however, perfect knowledge of the second-order statistics of the process for $H_{k,n}$ is assumed. Accordingly,

$$r_{HH}(l) = \frac{E\left[ H_{k,n} H_{k,n+l} \right]}{C/N_0} \qquad (12)$$

where $r_{HH}(l)$ is the normalized auto-correlation of the fade process at time-offset $l$, E denotes expected value, and $C/N_0$ is the carrier to noise-ratio.

By applying the orthogonality principle as illustrated in equation (13) as follows:

$$E\left[ \left( H_{k,n} - \hat{H}_{k,n} \right) \mathbf{Z}_k^\dagger \right] = \mathbf{0} \qquad (13)$$

This yields the following equation (14) to find the coefficients m.

$$\mathbf{m}^\dagger = \begin{bmatrix} r_{HH}(-3) & r_{HH}(1) \end{bmatrix} \left( \begin{bmatrix} 1 & r_{HH}(4) \\ r_{HH}(-4) & 1 \end{bmatrix} + \frac{N_0}{C} \mathbf{I} \right)^{-1} \qquad (14)$$

where I is the $2 \times 2$ identity matrix.

When combining interlaces, whether in frequency or time domain, certain timing adjustments are necessitated due to phase shift between pilot tones at a current n OFDM symbol and previous interlaces. Known fine timing tracking algorithms, for example, retard or advance the position of the FFT window at a sample server (to be discussed later). These timing adjustments correspond to phase shifts in the frequency-domain and thus affect channel estimation: The pilot tones at time $n$ which have a phase shift compared with the previous interlaces and, thus, channel estimation should be configured to correct for this phase shift to combine the interlace buffers. The advance or retarding of the FFT window may be also referred to as an advance or retard of the sampling of the OFDM symbol.

No matter which methodology used to determine the combining coefficients is chosen, in OFDM systems the AGC (automatic gain control) can limit the performance of the interlace combining. As a visual example, FIG. 4 illustrates a plot of the channel gain without automatic gain control (AGC). Without AGC, the plot of the channel gain smoothly changes. When AGC is utilized in a receiver, such as AGC 103, the gain of the receiver is adjusted such that the samples within one symbol (or more precisely within the FFT window) have a roughly constant power. This gain adjustment, which may include analog stages (like a Low Noise Amplifier, LNA) and/or digital stages (like a Digital Variable Gain Amplifier, DVGA) enables the receiver to operate with fewer bits in the blocks after the adjustment since the dynamic range of the signal is reduced

As can be seen from FIG. 5, the smoothly changing channel of FIG. 4 is "chopped" up in pieces with discontinuities by the AGC. Furthermore, this effect of the AGC on channel estimation is more pronounced the more interlaces that are combined: It is recognized, however, that performance of the receiver when combining interlaces is improved if the discontinuities introduced by the AGC are "reversed" or negated. This may be most efficiently effected by changing the combining coefficients $m_{l,k}$ to reverse the effects of the AGC. In mathematical terms, the pilot observations in any receiver can be represented by the following equation:

$$P_{k,n} = g(n) Z_{k,n}, \qquad (15)$$

where g(n) is the AGC gain (e.g., the combined LNA/DVGA) at a time n and $Z_{k,n}$ represents a theoretical pilot observation without AGC. The value $Z_{k,n}$ may be further defined as follows:

$$Z_{k,n} = H_{k,n} + \eta_{k,n}, \qquad (16)$$

where $H_{k,n}$ is the actual complex channel coefficient of a carrier k at a time n, and $\eta_{k,n}$ is the complex additive white Gaussian noise (AWGN). Thus, an interlace combining filter in the channel estimation block operates on the AGC adjusted observations according to equation (17) below in order to normalize the AGC gain.

$$P_{k,m} \frac{g(n)}{g(m)} \qquad (17)$$

As may be seen in this equation, this normalization is effected by multiplying the pilot tone for a $m^{th}$ interlace by the ratio of an AGC gain g(n) for a symbol time $n$ to an AGC gain g(m) for an interlace $m$. For purposes of the present disclosure, the ratio of g(n) to g(m) is termed a normalization gain, which serves to normalize the AGC gain to a predetermined time $n$. It is noted that for the above relationship (17), in one example the value $m$ may be bounded according to the condition $(n-3) \leq m \leq (n+3)$ in the instance of a 7 interlace combining scheme for DVB or ISDB systems. This may be less for FLO systems or other systems having interlace combining schemes of less than 7 interlaces.

It is noted that the AGC adjustment may be performed in time or frequency domain with the exact same performance benefits. The adjustment may be thus incorporated into the interlace filter by defining an adjusted combining coefficient $\overline{m}_{l,k}$ according to the following relationship (18).

$$\overline{m}_{l,k} = m_{l,k} \frac{g(n)}{g(n-(k-l \cdot 4))}. \qquad 18)$$

In equation (18) the combining coefficient $m_{l,k}$ is multiplied by the normalized AGC gain, which may be derived from equation (17). It is noted that for equation (18) a system using 4 interlaces is assumed, such as the system that was illustrated in FIG. 2. Therefore, the value of $m$ may be represented by $(n-(k-l \cdot 4))$ in a four interlace scheme. One skilled in the art will appreciate that equation (18) may be modified to account for other systems, such as the 2 interlace system used in FLO systems. This adjusted coefficient may then be substituted in equation (1) above, for example, to determine a channel estimate $\overline{H}_{k,n}$. The AGC gain is, however, typically not stored linearly but in log domain with $b$ bits precision, i.e., $l(n) = \text{rnd}(2^b \log_2(g(n)))$. Thus equation (18) becomes:

$$\overline{m}_{l,k} = 2^{(l(n)-l(n-(k-l \cdot 4)))/2^b} m_{l,k}. \qquad (19)$$

The integer portion of $(l(n)-l(n-(k-l \cdot 4)))/2^b$ in equation (19) corresponds to a simple shift. Thus, the power of 2 of the non-integer portion can be approximated with a polynomial of degree 2. One skilled in the art will appreciate that equation (19) can be efficiently implemented in a digital signal processor (DSP). Since the result could potentially exceed the bit-width of the FFT engine, the result needs to be saturated to the bit-width of the FFT engine.

FIG. 6 illustrates a flow diagram of a method for determining combining coefficients in a multi carrier OFDM system where the coefficients are normalized to account for the effects of the AGC. As shown, the method 600 begins at a start block 602. Flow then proceeds to block 604 where a normalization gain of an applied automatic gain control is determined. The normalization gain is normalized to a predefined time, such as a symbol time $n$. The procedure of block 604 effects finding the ratio $g(n)/g(m)$ discussed above in connection with equations (17), (18), and (19). After determining the normalization gain in block 604, flow proceeds to block 606 where two or more combining coefficients for an interlace filter are determined. The coefficients may be determined to any one of a number of known predetermined criteria, such as through linear interpolation or MMSE as discussed above. It is noted that block 606, although shown sequentially after block 604, the operation of block 606 may alternatively occur prior to the operation of block 604 or concurrent with the operation of block 604. It is further noted that a processor 121, such as a digital signal processor (DSP), the channel estimation block 118, a combination thereof, or any other suitable means may effect the operations of blocks 604 and 606, for example.

After the operations of blocks 604 and 606 are completed, flow proceeds to block 608 where the combining coefficients (e.g., $m_{l,k}$) are modified based on the determined normalization gain. This operation was described previously in connection with equations (18) and (19), where a modified or adjusted coefficient $\overline{m}_{l,k}$ is calculated. It is noted that a digital signal processor (DSP), such as DSP 121, the channel estimation block 118, a combination thereof, or any other suitable means, may effect the functionality of block 608. After the adjusted or modified combining coefficients are determined, the process 600 ends at block 610. The combining coefficients are then used by the interlace filter (e.g., 118) to determine a channel estimate, as discussed above and also in the related application entitled "TIMING ADJUSTMENTS FOR CHANNEL ESTIMATION IN A MULTI CARRIER SYSTEM" having a Attorney Docket No. 061615U1, filed concurrently herewith. It is noted that the process 600 is continually repeated during reception and processing of signals (e.g., channel estimation) in a transceiver.

While, for purposes of simplicity of explanation, the methodology is shown and described as a series or number of acts, it is to be understood that the processes described herein are not limited by the order of acts, as some acts may occur in different orders and/or concurrently with other acts from that shown and described herein. For example, those skilled in the art will appreciate that a methodology could alternatively be represented as a series of interrelated states or events, such as in a state diagram. Moreover, not all illustrated acts may be required to implement a methodology in accordance with the subject methodologies disclosed herein.

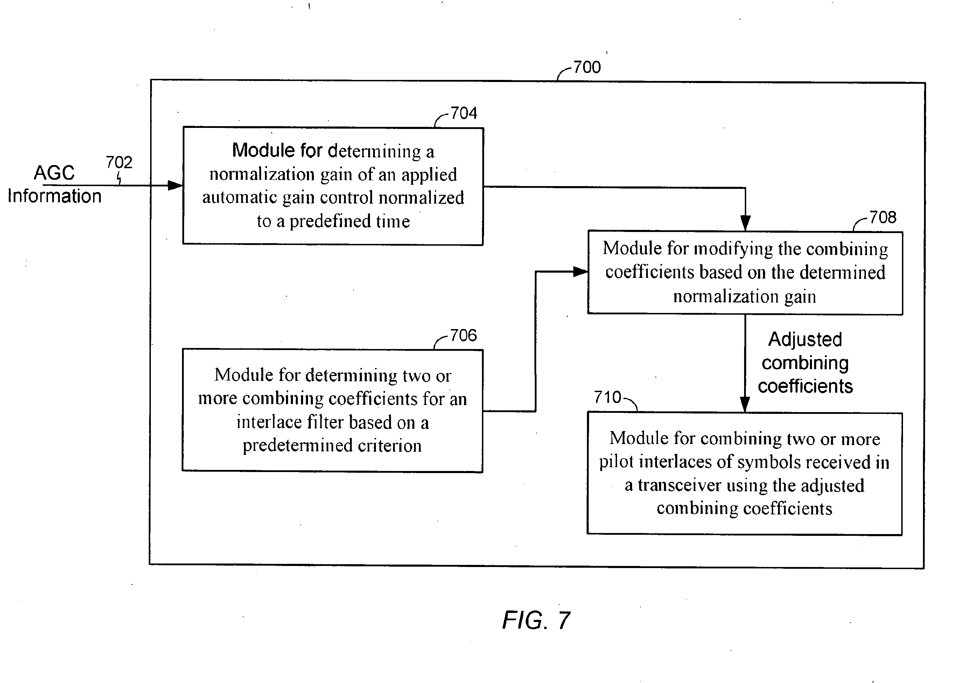

FIG. 7 illustrates an apparatus 700 for determining combining coefficients for channel estimation in a wireless device. The apparatus 700 receives automatic gain control (AGC) gain information at an input 702, which delivers the signal to a module 704 for determining a normalization gain of an applied automatic gain control normalized to a predefined time. As an example, input 702 may receive the AGC gain information from the AGC, such as AGC 103 via a communication link 122 as illustrated in FIG. 1. Additionally, module 704 may be implemented by channel estimation and interlace filter 118, DSP 121, a combination thereof or any other suitable processing means

Apparatus 700 also includes a module 706 for determining two or more combining coefficients for an interlace filter based on a predetermined criterion. Module 706 may be implemented by channel estimation block 118 in FIG. 1, a DSP (121), a combination thereof, as examples, or any other suitable processing means.

The determined normalization gain is output by means 704 and two or more combining coefficients are output by module 706. Both of these outputs are input to module 708 for modifying the combining coefficients based on the determined normalization gain. As discussed previously, module 708 may modify or adjust the coefficients by multiplying the normalization gain with the combining coefficient to achieve the adjusted combining coefficients. It is noted that module 708 may be used to effect one of equations (17)-(19) above. Further, module 708 may be implemented, for example, by channel estimation block 118, DSP 121, or any combination thereof.

The adjusted combining coefficients are output by module 708 for use by other processing in a transceiver to determine a channel estimate of a received OFDM signal. In a particular example in connection with determination of the channel estimate, FIG. 7 illustrates a module 710 within apparatus 700 for combining two or more pilot interlaces of symbols received in a transceiver using the adjusted combining coefficients. Module 710 may be implemented by the channel estimation unit and interlace filter 118 as shown in FIG. 1, as an example. It is also noted here that apparatus 700 may be implemented within a transceiver, such as an OFDM transceiver, and may consist of hardware, software, firmware, or any combination thereof.

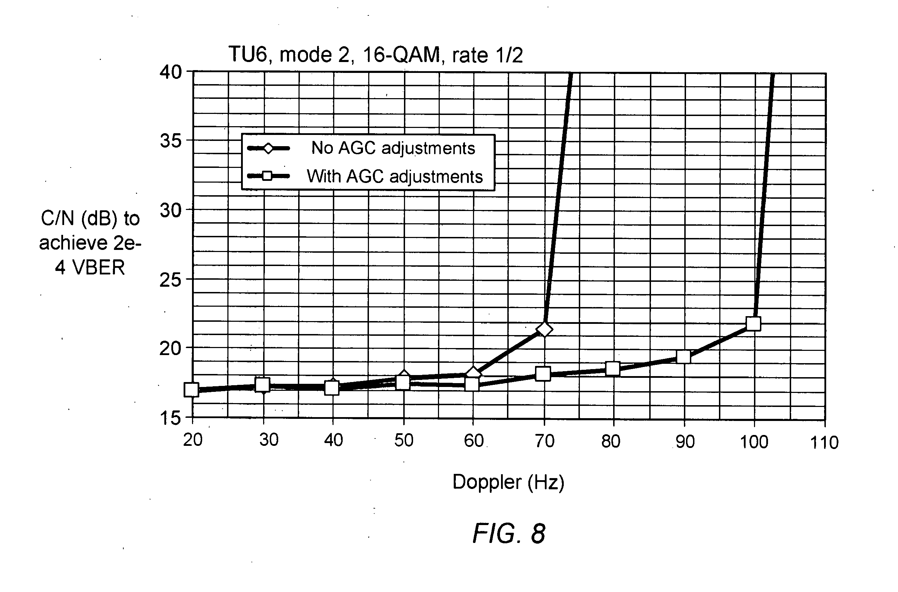

FIG. 8 gives a graphic example of simulation results evincing a performance improvement achieved using the AGC adjustments discussed herein. This figure illustrates the carrier-to-noise ratio (C/N), which is specified in dB, required to achieve a bit error rate after Viterbi decoding (VBER) of $2\times 10^{-4}$ in a typical urban channel with 6 paths (TU6) and varying maximum Doppler frequency, as an example. As may be seen in the figure, transceiver performance is improved for high speeds. In particular, a transceiver becomes operable at a maximum Doppler of approximately 100Hz when using AGC adjustments (see e.g., the plot demarcated with squares), whereas without AGC adjustments the transceiver is limited to 70Hz (see e.g., the plot demarcated with diamonds).

In light of the foregoing discussion, one skilled in the art will appreciate that the disclosed apparatus and methods effect improved channel estimation performance of receiver portion of a transceiver. This is accomplished in particular, by reversing the discontinuities introduced by AGC through determination of a normalization gain, which is normalized to particular symbol time. This normalization gain, in turn, is used to adjust combining coefficients used in an interlace filter for determining channel estimation.

It is understood that the specific order or hierarchy of steps in the processes disclosed is an example of exemplary approaches. Based upon design preferences, it is understood that the specific order or hierarchy of steps in the processes may be rearranged while remaining within the scope of the present disclosure. The accompanying method claims present elements of the various steps in a sample order, and are not meant to be limited to the specific order or hierarchy presented.

Those skilled in the art will appreciate that information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

Those of skill would further appreciate that the various illustrative logical blocks, modules, circuits, and algorithm steps described in connection with the embodiments disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present disclosure.

The various illustrative logical blocks, modules, and circuits described in connection with the embodiments disclosed herein may be implemented or performed with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The steps of a method or algorithm described in connection with the embodiments disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of storage medium known in the art. An exemplary storage medium (e.g., memory 124 in FIG. 1) is coupled to the processor such the processor can read information from, and write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

The examples described above are merely exemplary and those skilled in the art may now make numerous uses of, and departures from, the above-described examples without departing from the inventive concepts disclosed herein. Various modifications to these examples may be readily apparent to those skilled in the art, and the generic principles defined herein may be applied to other examples; e.g., in an instant messaging service or any general wireless data communication applications, without departing from the scope of the appended claims. Thus, the scope of the disclosure is not intended to be limited to the examples shown herein but is to be accorded the widest scope consistent with the principles and novel features disclosed herein. The word "exemplary" is used exclusively herein to mean "serving as an example, instance, or illustration." Any example described herein as "exemplary" is not necessarily to be construed as preferred or advantageous over other examples. Accordingly, the novel aspects described herein are to be defined solely by the scope of the following claims.

**Claims**

1. A method for adjusting for the effects of automatic gain control when combining pilot interlaces using an interlace combining filter of a communication system, the method comprising:

   determining (604) a normalization gain of an applied automatic gain control normalized to a predefined time;
   determining (606) two or more coefficients of the interlace combining filter based on a predetermined criterion; and
   modifying (608) each of the two or more coefficients based on the determined normalization gain to yield adjusted coefficients.

2. The method as defined in claim 1, wherein the modifying (608) the coefficients includes calculating the product of normalization gain and at least one of the two or more coefficients.

3. The method as defined in claim 1, wherein the predetermined criterion includes at least one of linear interpolation and minimization of minimum mean square error.

4. The method as defined in claim 1, further comprising:

combining two or more pilot interlaces of symbols received in a transceiver using the adjusted coefficients of the interlace combining filter.

5. The method as defined in claim 4, further comprising:

obtaining a channel estimate based on the combined pilot interlaces.

6. The method as defined in claim 5, further comprising:

demodulating data contained in a symbol using the channel estimate.

7. The method as defined in claim 4, wherein the symbols are orthogonal frequency division multiplexed symbols.

8. The method as defined in claim 4, wherein the combining the two or more pilot interlaces is performed in one of frequency domain and time domain.

9. An apparatus for adjusting for the effects of automatic gain control when combining pilot interlaces using an interlace combining filter of a communication system, comprising:

means (704) for determining a normalization gain of an applied automatic gain control normalized to a predefined time;
means (706) for determining two or more coefficients of the interlace combining filter based on a predetermined criterion; and
means (708) for modifying each of the two or more combining coefficients based on the determined normalization gain to yield adjusted coefficients.

10. The apparatus as defined in claim 9, wherein the means (708) for modifying the coefficients further includes means for calculating the product of normalization gain and at least one of the two or more coefficients.

11. The apparatus as defined in claim 9, wherein the predetermined criterion utilized by the means for determining two or more coefficients for an interlace combining filter includes at least one of linear interpolation and minimization of minimum mean square error.

12. The apparatus as defined in claim 9, further comprising:

means for combining two or more pilot interlaces of symbols received in a transceiver using the adjusted coefficients of the interlace combining filter.

13. The apparatus as defined in claim 12, further comprising:

means for obtaining a channel estimate based on combined pilot interlaces.

14. The apparatus as defined in claim 12, wherein the apparatus is adapted to demodulate data contained in the symbols using the corrected channel estimate.

15. A computer program product for adjusting for the effects of automatic gain control when combining pilot interlaces using an interlace combining filter of a communication system, comprising:

a computer-readable medium comprising:

code for causing a computer to determine a normalization gain of an applied automatic gain control normalized to a predefined time;

code for causing the computer to determine two or more coefficients of the interlace combining filter based on a predetermined criterion; and

code for causing the computer to modify each of the two or more coefficients based on the determined normalization gain to yield adjusted coefficients.

**Patentansprüche**

1. Ein Verfahren zum Anpassen bzw. Einstellen hinsichtlich der Auswirkungen von Effekten einer automatischen Verstärkungssteuerung beim Kombinieren von Pilot-Interlaces unter Verwendung eines Interlace-Kombinationsfilters eines Kommunikationssystems, wobei das Verfahren Folgendes aufweist:

   Bestimmen (604) einer Normalisierungsverstärkung einer angewandten automatischen Verstärkungssteuerung, die auf eine vordefinierte Zeit normalisiert ist;

   Bestimmen (606) von zwei oder mehr Koeffizienten des Interlace-Kombinationsfilters basierend auf einem vorbestimmten Kriterium; und

   Modifizieren (608) jedes der beiden oder mehr Koeffizienten basierend auf der bestimmten Normalisierungsverstärkung, um angepasste Koeffizienten zu erhalten.

2. Verfahren nach Anspruch 1, wobei das Modifizieren (608) der Koeffizienten das Berechnen des Produkts der Normalisierungsverstärkung und mindestens eines der zwei oder mehr Koeffizienten aufweist.

3. Verfahren nach Anspruch 1, wobei das vorbestimmte Kriterium eine lineare Interpolation und/oder eine Minimierung des minimalen mittleren quadratischen Fehlers aufweist.

4. Verfahren nach Anspruch 1, das weiter Folgendes aufweist:

   Kombinieren von zwei oder mehr Pilot-Interlaces von Symbolen, die in einem Transceiver empfangen werden, unter Verwendung der angepassten Koeffizienten des Interlace-Kombinationsfilters.

5. Verfahren nach Anspruch 4, das weiter Folgendes aufweist:

   Erlangen einer Kanalschätzung basierend auf den kombinierten Pilot-Interlaces.

6. Verfahren nach Anspruch 5, das weiter Folgendes aufweist:

   Demodulieren von Daten, die in einem Symbol enthalten sind, unter Verwendung der Kanalschätzung.

7. Verfahren nach Anspruch 4, wobei die Symbole orthogonale frequenzgemultiplexte Symbole sind.

8. Verfahren nach Anspruch 4, wobei das Kombinieren der zwei oder mehr Pilot-Interlaces in entweder der Frequenz-Domain oder der Zeit-Domain durchgeführt wird.

9. Eine Vorrichtung zum Anpassen hinsichtlich der Auswirkungen von Effekten einer automatischen Verstärkungssteuerung beim Kombinieren von Pilot-Interlaces unter Verwendung eines Interlace-Kombinationsfilters eines Kommunikationssystems, die Folgendes aufweist:

   Mittel (704) zum Bestimmen einer Normalisierungsverstärkung einer angewandten automatischen Verstärkungssteuerung, die auf eine vordefinierte Zeit normalisiert ist;

   Mittel (706) zum Bestimmen von zwei oder mehr Koeffizienten des Interlace-Kombinationsfilters basierend auf einem vorbestimmten Kriterium; und

   Mittel (708) zum Modifizieren jedes der zwei oder mehr Kombinationskoeffizienten basierend auf der bestimmten Normalisierungsverstärkung, um die angepassten Koeffizienten zu erhalten.

10. Vorrichtung nach Anspruch 9, wobei die Mittel (708) zum Modifizieren der Koeffizienten weiter Mittel zum Berechnen des Produkts der Normalisierungsverstärkung und mindestens eines der zwei oder mehr Koeffizienten beinhaltet.

11. Vorrichtung nach Anspruch 9, wobei das vorbestimmte Kriterium, das von dem Mittel zum Bestimmen von zwei oder mehr Koeffizienten für einen Interlace-Kombinationsfilter verwendet wird, eine lineare Interpolation und/oder eine Minimierung des minimalen mittleren quadratischen Fehlers beinhaltet.

12. Vorrichtung nach Anspruch 9, die weiter Folgendes aufweist:

Mittel zum Kombinieren von zwei oder mehr Pilot-Interlaces von Symbolen,
die in einem Transceiver empfangen wurden, unter Verwendung der angepassten Koeffizienten des Interlace-Kombinationsfilters.

13. Vorrichtung nach Anspruch 12, die weiter Folgendes aufweist:

Mittel zum Erlangen einer Kanalschätzung basierend auf kombinierten Pilot-Interlaces.

14. Vorrichtung nach Anspruch 12, wobei die Vorrichtung angepasst ist, um unter Verwendung der korrigierten Kanalschätzung Daten zu demodulieren, die in den Symbolen enthalten sind.

15. Ein Computerprogrammprodukt zum Anpassen hinsichtlich der Auswirkungen von Effekten einer automatischen Verstärkungssteuerung beim Kombinieren von Pilot-Interlaces unter Verwendung eines Interlace-Kombinationsfilters eines Kommunikationssystems, das Folgendes aufweist:

ein computerlesbares Medium, das Folgendes aufweist:

Code um zu bewirken, dass ein Computer eine Normalisierungsverstärkung einer angewandten automatischen Verstärkungssteuerung bestimmt, die auf eine vordefinierte Zeit normalisiert ist;
Code um zu bewirken, dass der Computer zwei oder mehr Koeffizienten des Interlace-Kombinationsfilters basierend auf einem vorbestimmten Kriterium bestimmt; und
Code um zu bewirken, dass der Computer jeden der zwei oder mehr Koeffizienten basierend auf der bestimmten Normalisierungsverstärkung modifiziert, um angepasste Koeffizienten zu erhalten.

## Revendications

1. Procédé d'ajustement des effets d'une commande automatique de gain quand on combine des entrelacements pilotes en utilisant un filtre de combinaison d'entrelacements d'un système de communication, ce procédé comprenant :

déterminer (604) un gain de normalisation d'une commande automatique de gain appliquée normalisée sur un instant prédéterminé ;
déterminer (606) deux ou plusieurs coefficients du filtre de combinaison d'entrelacements sur la base d'un critère prédéterminé ; et
modifier (608) chacun des deux ou plusieurs coefficients sur la base du gain de normalisation déterminé pour fournir des coefficients ajustés.

2. Procédé selon la revendication 1, dans lequel la modification (608) des coefficients inclut le calcul du produit du gain de normalisation et d'au moins un des deux ou plusieurs coefficients.

3. Procédé selon la revendication 1, dans lequel le critère prédéterminé inclut au moins une interpolation linéaire et une minimisation de l'erreur des moindres carrés.

4. Procédé selon la revendication 1, comprenant en outre :

combiner deux ou plusieurs entrelacements pilotes de symboles reçus dans un émetteur-récepteur en utilisant les coefficients ajustés du filtre de combinaison d'entrelacements.

5. Procédé selon la revendication 4, comprenant en outre :

obtenir une estimation de canal sur la base des entrelacements pilotes combinés.

6. Procédé selon la revendication 5, comprenant en outre :

   démoduler des données contenues dans un symbole en utilisant l'estimation de canal.

7. Procédé selon la revendication 4, dans lequel les symboles sont des symboles multiplexés par séparation de fréquence orthogonale.

8. Procédé selon la revendication 4, dans lequel la combinaison des deux ou plus entrelacements pilotes est réalisée dans le domaine fréquentiel ou dans le domaine temporel.

9. Dispositif d'ajustement des effets d'une commande automatique de gain quand on combine des entrelacements pilotes en utilisant un filtre de combinaison d'entrelacements d'un système de communication, comprenant :

   des moyens (704) pour déterminer un gain de normalisation d'une commande automatique de gain appliquée normalisée sur un instant prédéterminé ;
   des moyens (706) pour déterminer deux ou plusieurs coefficients du filtre de combinaison d'entrelacements sur la base d'un critère prédéterminé ; et
   des moyens (708) pour modifier chacun des deux ou plusieurs coefficients sur la base du gain de normalisation déterminé pour fournir des coefficients ajustés.

10. Dispositif selon la revendication 9, dans lequel les moyens (708) pour modifier les coefficients incluent des moyens de calcul du produit du gain de normalisation et d'au moins un des deux ou plusieurs coefficients.

11. Dispositif selon la revendication 9, dans lequel le critère prédéterminé utilisé par les moyens pour déterminer deux ou plusieurs coefficients du filtre de combinaison d'entrelacements inclut au moins une interpolation linéaire et une minimisation de l'erreur des moindres carrés.

12. Dispositif selon la revendication 9, comprenant en outre :

   des moyens pour combiner deux ou plusieurs entrelacements pilotes de symboles reçus dans un émetteur-récepteur en utilisant les coefficients ajustés du filtre de combinaison d'entrelacements.

13. Dispositif selon la revendication 12, comprenant en outre :

   des moyens pour obtenir une estimation de canal sur la base des entrelacements pilotes combinés.

14. Dispositif selon la revendication 12, dans lequel l'appareil est adapté à démoduler des données contenues dans les symboles en utilisant l'estimation de canal corrigée.

15. Produit programme d'ordinateur pour régler les effets d'une commande automatique de gain quand on combine des entrelacements pilotes en utilisant un filtre de combinaison d'entrelacements dans un système de communication, comprenant :

   un milieu lisible par un ordinateur comprenant :

      un code pour amener un ordinateur à déterminer un gain de normalisation d'une commande automatique de gain appliquée normalisée sur un instant prédéterminé ;
      un code pour amener l'ordinateur à déterminer deux ou plusieurs coefficients du filtre de combinaison d'entrelacements sur la base d'un critère prédéterminé ; et
      un code pour amener l'ordinateur à modifier chacun des deux ou plus coefficients sur la base du gain de normalisation déterminé pour conduire à des coefficients ajustés.

FIG. 1

OFDM Carrier Number

| | 0 | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|---|
| 0 | $p_{0,0}$ | | | | | | | | | | | | $p_{1,0}$ | | | |
| 1 | | | | $p_{0,1}$ | | | | | | | | | | | | $p_{1,1}$ |
| 2 | | | | | | | $p_{0,2}$ | | | | | | | | | |
| 3 | | | | | | | | | | $p_{0,3}$ | | | | | | |
| 4 | $p_{0,0}$ | | | | | | | | | | | | $p_{1,0}$ | | | |
| 5 | | | | $p_{0,1}$ | | | | | | | | | | | | $p_{1,1}$ |

OFDM Symbol Time

*FIG. 2*

EP 2 130 338 B1

OFDM carrier number

OFDM symbol time

Interpolation in frequency

Interpolation in time

FIG. 3

*FIG. 4*

*FIG. 5*

600

Start — 602

↓

Determining a normalization gain of an applied automatic gain control normalized to a predefined time — 604

↓

Determining two or more combining coefficients for an interlace filter based on a predetermined criterion — 606

↓

Modifying each of the two or more combining coefficients based on the determined normalization gain — 608

↓

End — 610

*FIG. 6*

AGC Information 702 →

Module for determining a normalization gain of an applied automatic gain control normalized to a predefined time ⌐704

Module for modifying the combining coefficients based on the determined normalization gain ⌐708

Module for determining two or more combining coefficients for an interlace filter based on a predetermined criterion ⌐706

Adjusted combining coefficients

Module for combining two or more pilot interlaces of symbols received in a transceiver using the adjusted combining coefficients 710

⌐700

FIG. 7

TU6, mode 2, 16-QAM, rate 1/2

*FIG. 8*

EP 2 130 338 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 37376406 A
- US 77725107 A

- US 373764 A

### Non-patent literature cited in the description

- **LINDE L P.** An AGC strategy for adaptive digital modems in frequency hopping applications. *COMMUNICATIONS AND SIGNAL PROCESSING, 1989. COMSIG 1989. PROCEEDINGS., SOUTHERN AFRICAN CONFERENCE ON STELLENBOSCH,* 01 January 1989, ISBN 978-0-87942-713-9, 19-24